Europäisches Patentamt

European Patent Office

Office européen des brevets

(11) Publication number: 0 341 768 A2

# EUROPEAN PATENT APPLICATION

(21) Application number: 89201022.4

(22) Date of filing: 20.04.89

(51) Int. Cl.4: G11C 17/00

(30) Priority: 11.05.88 IT 2054088

(43) Date of publication of application:
15.11.89 Bulletin 89/46

(84) Designated Contracting States:
DE FR GB NL SE

(71) Applicant: SGS-THOMSON
MICROELECTRONICS S.p.A.
Via C. Olivetti, 2
I-20041 Agrate Brianza (MI)(IT)

(72) Inventor: Gastaldi, Roberto
Via Avezzana, 16
I-20139 Milano(IT)
Inventor: Dallabora, Marco
Via Pio IV, 22
I-20077 Melegnano (Milano)(IT)
Inventor: Casagrande, Giulio
Via Strettone, 8
I-20060 Vignate (Milano)(IT)

(74) Representative: Mittler, Enrico et al
c/o Marchi & Mittler s.r.l. Viale Lombardia, 20
I-20131 Milano(IT)

(54) EPROM memory using programming voltages taken from a single low voltage power supply.

(57) The EPROM memory comprising a semiconductor substrate (1) with source (3) drain (2) and channel (4) areas, a control gate (5) and a floating gate (6) uses for programming a drain voltage no higher than the low power supply voltage (Vcc) employed for normal operation of the memory and a control gate voltage taken from said power supply voltage (Vcc) through a voltage booster (8).

Fig.1

EP 0 341 768 A2

## EPROM memory using programming voltages taken from a single low voltage power supply

The present invention relates to an EPROM memory which uses programming voltages taken from a single low voltage power supply.

As is known, nonvolatile EPROM memories use memory cells consisting of MOS transistors comprising a semiconductor substrate provided with source and drain areas with an interposed channel area, a control gate and a floating gate completely immersed in silicon oxide between the control gate and the channel area. In the floating gate is stored a negative electric charge constituting the memorized information.

To programme the cell, i.e. transport the negative charge into the floating gate overcoming the potential barrier of the silicon oxide, use is made of the thermoionic emission of the electrons circulating in the MOS transistor channel, directing the carriers emitted to the floating gate by means of an appropriate electrical field generated by applying to the drain and control gate appropriate programming voltages.

More specifically, to the cell drain is applied a voltage such as to take the transistor into saturation. Under these conditions, around the drain area there is created an emptied zone which is the seat of a high electric field by means of which the electrons can be accelerated, thus acquiring the necessary energy to overcome the potential barrier of the oxide. A high voltage is also applied to the control gate of the cell in such a manner as to create an electrical field perpendicular to the channel, which is capable of directing the accelerated electrons to the floating gate.

In common practice the two programming voltages mentioned above are taken from a high outside supply voltage which is different from that used for the other functions of the memory. As a result the memory must be powered by two distinct voltages, one 5V for normal operation and the other 12V for programming. This requires two different pins for the two voltages.

The object of the present invention is to achieve an EPROM memory not requiring for programming a power supply voltage different from that otherwise provided for normal operation of the memory.

In accordance with the invention said object is achieved by an EPROM memory characterized in that it uses for programming a drain voltage no higher than the power supply voltage normally used for operation of the memory and a control gate voltage taken from said power supply voltage through a voltage booster.

In this manner a single low power supply voltage, the one used for normal operation of the memory, is capable of supplying both the voltages necessary for programming the memory.

This is made possible by the fact that between the two programming voltages there is a fundamental difference. While the voltage applied to the drain must supply energy to the electrons to make possible the phenomenon of thermoionic emission the voltage applied to the control gate has only the function of diverting a fraction of the energetic electrons to the floating gate. This latter voltage must hence be appropriately higher than that applied to the drain but it need not be accompanied by delivery of the high power needed for the drain voltage. This is the reason why the control gate voltage may be supplied by a voltage booster, which is otherwise unsuitable for delivery of appreciable power. The only requirement is that the memory cell be designed in such a manner as to be programmed with a drain voltage no higher than 5V because that is the voltage normally used for power supply of integrated circuits. Design of a cell of this type is not however a problem for the present knowledge of those skilled in the art.

At least three important advantages are provided by the present invention as follows: (a) saving of a pin in the memory package, (b) the possibility of on-board programming without having to provide a particular power supply to be used only for said programming, and (c) greater strength of the integrated circuit due to the fact that the high programming voltage applied to the control gate is not supplied by an outside feeder capable of supplying power so that it is easier to protect the device from the eventuality of an overvoltage in the programming phase which could damage it permanently.

The characteristics of the present invention will be better understood by observing the annexed drawings wherein:

FIG. 1 shows a typical nonvolatile memory cell of the EPROM type using programming voltages taken in accordance with the invention, and

FIG. 2 shows an example of a voltage booster usable for supplying the programming voltage to the control gate of the memory cell of FIG. 1.

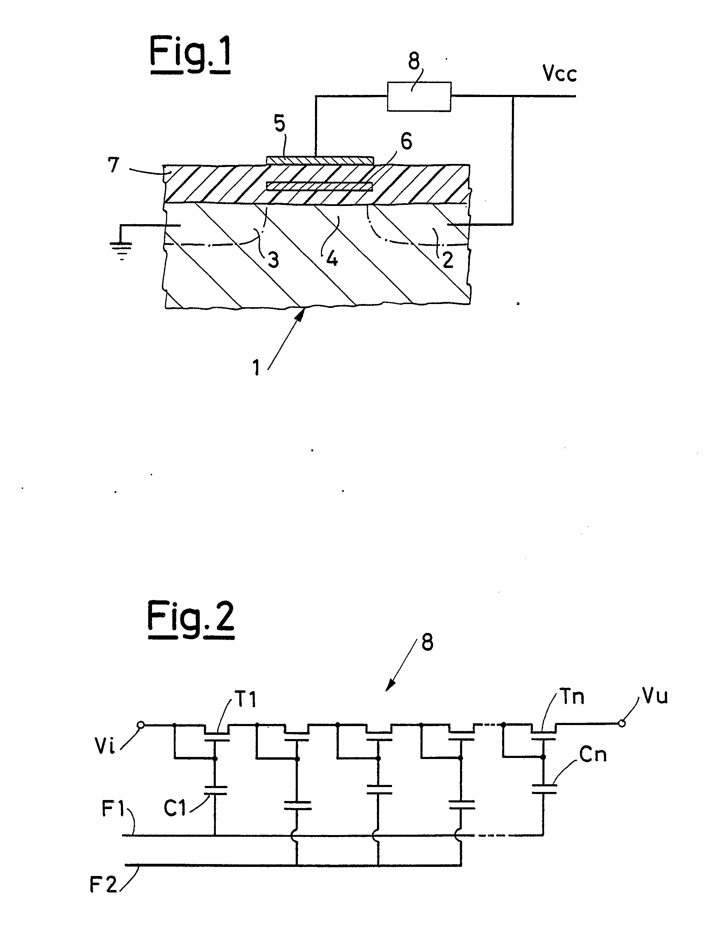

With reference to FIG. 1 there is illustrated an EPROM memory cell comprising a silicon substrate 1 provided with drain 2 and source 3 areas with an interposed channel area 4, a control gate 5 and a floating gate 6 completely immersed in silicon oxide 7 between the control gate 5 and the channel area 4.

In the programming phase the source area 3 is connected to ground while the drain area 2 is connected to the normal power supply voltage Vcc of 5V. To the control gate 5 is applied a higher programming voltage, 12.5V, also taken from the power supply voltage Vcc through a voltage booster 8.

The voltage booster 8 may be of any known type, e.g. as shown in FIG. 2, where T1-Tn are MOS transistors of the growth type, C1-Cn are condensers, F1 and F2 are the control phases of the voltage boosters, Vi is the input voltage and Vu is the output voltage. The relationship between the output and input voltages depends on the voltages of the control phase voltages F1, F2 in addition to the design data of the transistors T1-Tn and the condensers C1-Cn.

**Claims**

1. EPROM memory comprising a semiconductor substrate (1) provided with source (3) and drain (2) areas with an interposed channel area (4), a control gate (5) and a floating gate (6) immersed in oxide (7) between the control gate (5) and the channel area (4) characterized in that it uses for programming a drain voltage no higher than the power supply voltage (Vcc) employed for normal operation of the memory and a control gate voltage taken from said power supply voltage (Vcc) through a voltage booster (8).

2. EPROM memory in accordance with claim 1 characterized in that said power supply voltage (Vcc) is 5V while said control gate voltage is 12.5V.

## Fig.1

8

Vcc

5

6

7

3   4   2

1

## Fig.2

8

T1          Tn   Vu

Vi

C1          Cn

F1

F2